(19) Europäisches Patentamt
European Patent Office
Office européen des brevets

(11) **EP 2 562 795 A1**

(12) **EUROPEAN PATENT APPLICATION**
published in accordance with Art. 153(4) EPC

(43) Date of publication:
**27.02.2013 Bulletin 2013/09**

(21) Application number: **11771930.2**

(22) Date of filing: **14.04.2011**

(51) Int Cl.:
*H01L 21/301* (2006.01)     *C09J 7/02* (2006.01)
*C09J 11/06* (2006.01)       *C09J 133/04* (2006.01)
*C09J 167/00* (2006.01)      *H01L 21/304* (2006.01)

(86) International application number:
**PCT/JP2011/059247**

(87) International publication number:
**WO 2011/132595 (27.10.2011 Gazette 2011/43)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.04.2010   JP 2010097273**

(71) Applicant: **Nitto Denko Corporation**
**Ibaraki-shi, Osaka 567-8680 (JP)**

(72) Inventors:
• **OOISHI, Michihito**
  **Ibaraki-shi**
  **Osaka 567-8680 (JP)**

• **SHINTANI, Toshio**
  **Ibaraki-shi**
  **Osaka 567-8680 (JP)**

(74) Representative: **Schaeberle, Steffen**
  **Hoefer & Partner**
  **Patentanwälte**
  **Pilgersheimer Strasse 20**
  **81543 München (DE)**

(54) **ADHESIVE SHEET FOR SEMICONDUCTOR WAFER PROCESSING**

(57)     An adhesive sheet for processing of a semiconductor wafer has an adhesive layer disposed on at least one surface of a base substrate, the adhesive layer includes a base polymer, a plasticizer and a surfactant, an SP value of the plasticizer and the surfactant satisfies the relationship: $0.9 \leq$ (the plasticizer SP value)/(the surfactant SP value) $\leq 1.0$. The present invention has the object of providing an adhesive sheet for processing of a semiconductor wafer that exhibits superior storage stability under a range of environments, and that prevents contamination of the adherend after use.

EP 2 562 795 A1

**Description**

TECHNICAL FIELD

The present invention relates to an adhesive sheet for processing of a semiconductor wafer.

[BACKGROUND ART]

A semiconductor wafer forming a circuit pattern such as an IC or the like is subjected to processing such as back grinding processing or the like in order to reduce the thickness of the wafer as much as possible. During processing of the semiconductor wafer, a surface protecting sheet is adhered in advance to the circuit pattern forming surface by an automatic attaching apparatus in order to prevent breakage of the wafer, or contamination of or damage to the circuit pattern forming surface by grinding waste. After processing such as back grinding processing of the wafer, the surface protecting sheet is peeled and removed and the wafer is conveyed to a wafer washing step or the like. In subsequent steps, the wafer is configured into individual pieces and a processing sheet is used to proceed to a PKG manufacturing step.

This type of surface protecting sheet or processing sheet is a commonly known object that includes an adhesive sheet provided with an adhesive layer on a base substrate, and in which the adhesive layer includes addition of a plasticizer such as a phthalate ester including dioctyl phthalate, dibutyl phthalate, or the like.

However, when an adhesive sheet provided with an adhesive layer including the addition of a phthalate ester is stored under environmental conditions such as low temperature, high humidity or the like, a stain originating in the adhesive component is deposited on the adhesive layer surface. Consequently, contamination of the circuit pattern forming surface may result when adhering the adhesive sheet to the wafer.

Furthermore, when using this type of surface protecting sheet or processing sheet, the circuit pattern forming surface or the like after peeling and removal of the sheet must be prewashed using a hydrophilic organic solvent such as acetone, isopropyl alcohol, or the like, and then rinsed in water. As a result, problems arises such as the requirement for an environmental protection strategies in relation to use of the organic solvent in addition to an adverse effect on washing efficiency.

In contrast, an adhesive sheet that includes a water-soluble polymer such as polypropylene glycol as an adhesive component has been proposed (for example, Japanese Patent Application Laid-Open No. 5-335288).

However, a fundamental solution to the problem is not enabled even when using this type of adhesive sheet since there is a requirement for a water washing step due to the fact that the water soluble polymer bleeds onto the circuit pattern forming surface or the like.

Furthermore, the enactment of the REACH Regulation from June 1, 2007 includes the designation of phthalate esters as a high risk substance being a candidate for approval, and therefore there is the possibility of on-going use restrictions or use prohibition.

Disclosure of the Invention

Problem to be Solved

The present invention is proposed in light of the above circumstances and has the object of providing an adhesive sheet for processing of a semiconductor wafer that exhibits superior storage stability under a range of environments, and that prevents contamination of the adherend after use.

Means for Solving the Problem

The inventors conducted diligent research into storage stability of adhesive sheets for processing of a semiconductor wafer. As a result, they discovered (i) and (ii) as shown below and this led to the perfection of the present invention.

(i) In an adhesive containing a base polymer, a plasticizer and a surfactant, an ingredient which bleed out was unexpectedly only the surfactant, not the plasticizer.
(ii) By setting the relationship of SP values which is unconsidered up to now into the specific range, in a specific combination of a plasticizer and a surfactant used, it is possible to stably-store without deposition of a stain on an adherend side even under a variety of environments which include a high temperature and humidified environment.

That is, an adhesive sheet for processing of a semiconductor wafer of the present invention has an adhesive layer disposed on at least one surface of a base substrate,
the adhesive layer includes a base polymer, a polyester-based plasticizer and a surfactant,
SP values of the plasticizer and the surfactant satisfy the relationship:

$$0.9 \leq (SP\ value\ of\ the\ plasticizer)/(SP\ value\ of\ the\ surfactant)$$

$$\leq 1.0.$$

In this adhesive sheet for processing of a semiconductor wafer, it is preferably that the plasticizer is contained in a ratio of 10 to 50 parts by weight to 100 parts by weight of the base polymer.
Also, it is preferably that the surfactant is contained in a ratio of 1 to 10 parts by weight to 100 parts by weight of the base polymer.
Further, it is preferably that the base polymer includes an acrylic polymer.
Moreover, it is preferably that when the film thickness of the adhesive layer in the adhesive sheet is taken to be A $\mu$m, and a step on the surface of the wafer is taken to be B $\mu$m, and the film thickness A and the step B satisfies the relation $0.2 \leq B/A \leq 5.7$,
the initial lift amount d1 of the adhesive sheet from the step and the lift amount d2 of the adhesive sheet after 24 hours satisfy

$$(d2/d1) \times 100 \leq 110\ (\%).$$

Effect of the Invention

According to the present invention, it is possible to provide an adhesive sheet for processing of a semiconductor wafer that exhibits superior storage stability under a range of environments, and that prevents contamination of the adherend after use.

Brief Description of the Drawings

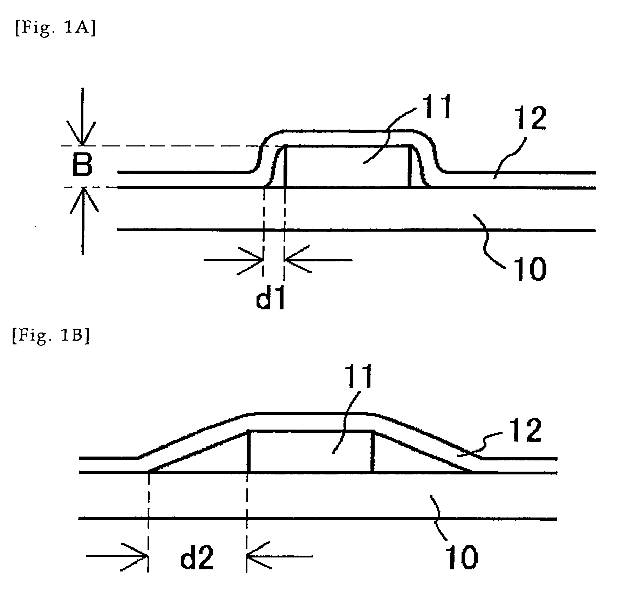

[Fig. 1A] is a schematic cross-sectional diagram for describing the initial lift amount d1 of the adhesive sheet to the step according to the present invention.
[Fig. 1B] is a schematic cross-sectional diagram for describing the lift amount d1 over time of the adhesive sheet to the step according to the present invention.

Detailed Description of the Preferred Embodiments

The adhesive sheet for processing of a semiconductor wafer according to the present invention (hereinafter simply may be referred to as "adhesive sheet") includes a base substrate and an adhesive layer disposed on at least one surface of the base substrate. The adhesive layer is formed by an adhesive containing at least a base polymer, a polyester-based plasticizer, and a surfactant.

(Plasticizer)

The plasticizer used in the present invention reduces the adhesive strength of the adhesive in relation to the adherend and is suitably a polyester-based plasticizer. Although the type of plasticizer may be suitably selected in relation to the adhesive that is used, it is suitably a substance that satisfies the solubility parameter (SP value) relationship that is described below.
The plasticizer is preferably a trimellitate-based polyester such as W-700 or the like manufactured by Dainippon Ink, an adipate-based polyester such as D620 manufactured by J-PLUS, a maleate-based polyester, a sebacate-based polyester, a benzoate-based polyester, an epoxy-based polyester, a polyether-based polyester, and the like. These substances may be used singly or in a combination of two or more.
The plasticizer is suitably used in a ratio of 10 to 50 parts by weight to 100 parts by weight of the base polymer, and is preferably used in 10 to 30 parts by weight. In that range, damage is prevented in relation to an adherend such as a semiconductor wafer during peeling by reason of an excessively high adhesive strength. Furthermore, bleeding onto the adhesive layer surface can be avoided and contamination of the adherend can be prevented.

(Surfactant)

The surfactant used in the present invention is a component for adjusting the adhesive strength in relation to the semiconductor wafer. Although any of a non-ionic, cationic, anionic surfactant may be used, use of a non-ionic surfactant is preferred. The actual type of surfactant may be suitably selected in relation to the adhesive that is used, and is suitably a substance that satisfies the SP value relationship that is described below.
Examples of the surfactant include an anionic surfactant such as an alkyl sulfate (such as Neogen R or the like manufactured by Dai-Ichi Kogyo Seiyaku), an alkyl phosphate (such as Electron Stripper N or the like manufactured by Kao) or the like; a cationic surfactant such as an aliphatic quaternary ammonium salt (such as Quartamin 24P manufactured by Kao), an aromatic quaternary ammonium salt (such as Catinal HC-100 or the like manufactured by Toho Chemical Industry) or the like; and a non-ionic surfactant such as a sorbitan-fatty acid ester (such as Rheodol SP-L10 or the like manufactured by Kao), a polyoxyethylene (such as Noigen EP-120A or the like manufactured by Dai-Ichi Kogyo Seiyaku), glycerin, ether, fatty acids or the like. These substances can be used singly or in combinations of two or more.
The surfactant is suitably used in a ratio of 1 to 10 parts by weight to 100 parts by weight of the base polymer, is preferably used in 1 to 5 parts by weight, and more preferably is used in 1 to 2 parts by weight. In that range, a conspicuous reduction in the adhesive force is avoided, and conformability in relation to the undulations on the semiconductor wafer pattern surface can be maintained.

(SP Value)

The SP value of the plasticizer and the surfactant that configure the adhesive layer described above preferably satisfies the relationship:

$$0.9 \leq (\text{SP value of the plasticizer})/(\text{SP value of the surfactant})$$
$$\leq 1.0.$$

As used herein, the SP value $\delta p$ of the plasticizer indicates a value that is estimated from Small's Formula as shown in Equation (1). The SP value $\delta s$ of the surfactant indicates a value that is estimated from the HLB value for the surfactant, and for example, indicates a value that is obtained from Equation (2) (Cited Reference: SP Chi no Kiso, Oyo to Keisanhoho, Hideki Yamamoto Eds. P54 - 56).

$$\delta p \ [(\text{J}/\text{cm}^3)^{1/2}] = \Sigma F/V \qquad (1)$$

Wherein, $\delta p$ denotes the solubility parameter, F is a constant related to the molecular interactions (depending on the type of substitution group and Small's constant as shown in Table 1), and V denotes the molar molecular volume.
Table 1

| | F [J$^{1/2}$/mol] | | F [J$^{1/2}$ /mol] |
|---|---|---|---|
| -CH$_3$ | 438 | H | 164 ~ 205 |
| -CH$_2$- | 272 | OH | - |
| CH$_2$= | 389 | O (ether) | 143 |
| CH- | 57 | CHO | 685 ~767 |
| -CH(CH$_3$)$_2$ | 933 | CO (ketone) | 583 |
| -CH= | 227 | COOH | 798 ~ 839 |
| -C- | 190 | COO (ester) | 634 |
| C= | 39 | CH$_3$COO | 1072 |
| CHC- | 583 | CN | 839 |
| -C=C- | 454 | Cl (mean) | 532 |
| -CH=CH$_2$- | 616 | Cl (single) | 552 |
| Phenyl | 1504 | Cl (as in CCl$_2$) | 532 |
| Cyclohexyl | - | Cl (as in CCl$_3$) | 511 |
| Phenylene (o, m, p) | 1346 | Br (shingle) | 696 |

(continued)

| | F [$J^{1/2}$/mol] | | F [$J^{1/2}$/mol] |
|---|---|---|---|
| Naphenyl | 2345 | I (single) | 870 |
| Five-membered ring | 215 ~ 235 | $CF_2$ (n-hydrocarbons) | 307 |
| Six-membered ring | 194 ~ 215 | $CF_3$ (n-hydrocarbons) | 552 |
| Conjugation | 41 ~ 61 | S (sulfides) | 460 |
| $NO_3$ (nitrates) | 900 | SH (thiols) | 644 |
| $NO_2$ (aliphalic nitro) | 900 | $PO_4$ (organic phosphates) | 1023 |

$$\delta s[(cal/cm^3)^{1/2}] = (118.8 + 6.0)/(54\text{-HLB}) \qquad (2)$$

As used herein, the HLB value is a value digitalizing the balance of the hydrophilic and hydrophobic groups in a non-ionic surfactant, and expresses the level of the hydrophilic characteristics of a non-ionic surfactant. The HLB value is a value obtained from Equation (3).

$$\text{HLB} = (\text{molecular weight hydrophilic group component}/$$
$$\text{molecular weight surfactant}) \times 100/5 \qquad (3)$$

(Adhesive layer)

The adhesive contained in the adhesive layer used in the present invention, that is to say, the adhesive containing the plasticizer and the surfactant preferably has an adhesive strength relative to a mirror wafer of about 0.1 to 1.0 N/20mm. Within this range, conformability in relation to the undulations on the semiconductor wafer pattern surface can be ensured, and breakage of the semiconductor wafer during peeling can be effectively prevented.

The adhesive suitably has a gel fraction of about of 30 to 90%, and preferably about 30 to 70%. When the gel fraction is within this range, residual adhesive that results from insufficient cohesive strength can be prevented. In addition, close adhesion to the adherend can be ensured and conformability in relation to the undulations on the semiconductor wafer pattern surface can be maintained.

The gel fraction of the adhesive is such that an adhesive is obtained from a tape, the weight of the obtained adhesive ($W_1$) is measured, and after one week immersion of the adhesive in ethyl acetate, the solvent portion is dried, and the weight of the residual gel ($W_2$) is measured to thereby obtain a value calculated by Equation (4).

$$\text{Gel Fraction (\%)} = (W_2/W_1) \times 100 \qquad (4)$$

There is no particular limitation on the base polymer in the adhesive configuring the adhesive layer, and examples may be suitably selected from a base polymer that configures a known adhesive such as a rubber-based adhesive, an acrylic adhesive, a polyamide-based adhesive, a silicon-based adhesive, a polyester-based adhesive, and urethane-based adhesive, or the like. Of these adhesives, an acrylic polymer that is the base polymer that configures an acrylic adhesive exhibits various superior characteristics such as heat resistance, weathering performance or the like, and may be suitably used to enable expression of desired characteristics by selection of the type of monomer component that configures the acrylic polymer.

The acrylic copolymer that is the base polymer of the acrylic adhesive is configured by a (meth)acrylic alkyl ester as a main monomer component.

Examples of the (meth)acrylic alkyl ester include a $C_{1-20}$ alkyl (meth)acrylate (preferably a $C_{1-12}$ alkyl (meth)acrylate, and more preferably a $C_{1-8}$ alkyl (meth)acrylate) such as methyl (meth)acrylate, ethyl (meth)acrylate, propyl (meth) acrylate, isopropyl (meth)acrylate, butyl (meth)acrylate, isobutyl (meth)acrylate, s-butyl (meth)acrylate, t-butyl (meth) acrylate, pentyl (meth)acrylate, hexyl (meth)acrylate, heptyl (meth)acrylate, octyl (meth)acrylate, 2-ethylhexyl (meth) acrylate, isooctyl (meth)acrylate, nonyl (meth)acrylate, isononyl (meth)acrylate, decyl (meth)acrylate, isodecyl (meth) acrylate, undecyl (meth)acrylate, dodecyl (meth)acrylate, tridecyl (meth)acrylate, tetradecyl (meth)acrylate, pentadecyl (meth)acrylate, octadecyl (meth)acrylate, nonadecyl (meth)acrylate, eicosyl (meth)acrylate or the like. These alkyl (meth) acrylates may be used singly or in a combination of two or more.

The acrylic copolymer may include a unit that is corresponding to the other monomer component which is copolymerizable with the alkyl (meth)acrylate if desired for the purpose of modifying cohesion force, heat resistance, cross-linking performance or the like.

Examples of such monomer component include, for example,

carboxyl-containing monomers such as acrylic acid, methacrylic acid, carboxyethyl acrylate, carboxypentyl acrylate, itaconic acid, maleic acid, fumaric acid and crotonic acid;

hydroxyl group-containing monomers such as hydroxybutyl (meth)acrylate, hydroxyhexyl (meth)acrylate, hydroxyoctyl (meth)acrylate, hydroxydecyl (meth)acrylate, hydroxyrauryl (meth)acrylate, (4-hydroxymethyl cyclohexyl)methyl(meth) acrylate;

sulfonate-containing monomers such as styrenesulfonate, allylsulfonate, 2-(meth) acrylamide-2-methyl propanesulfonate, (meth)acrylamide propanesulfonate, sulfopropyl (meth)acrylate, (meth)acryloyl oxynaphthalenesulfonate;

phosphate-containing monomers such as 2-hydroxyethyl acryloylphosphate;

(N-substituted) amide-based monomers such as (meth)acrylamide, N,N-dimethyl (meth)acrylamide, N-butyl (meth)acrylamide, N-methylol (meth)acrylamide, N-methylolpropane (meth)acrylamide;

aminoalkyl (meth)acrylate-based monomers such as aminoethyl (meth)acrylate, N,N-dimethylamino(meth)acrylate, t-butylaminoethyl (meth)acrylate;

alkoxyalkyl (meth)acrylate-base monomers;

maleimide-based monomers such as N-cyclohexyl maleimide, N-isopropyl maleimide, N-lauryl maleimide, N-phenylmareimide;

itaconimide-based monomers such as N-methyl itaconimide, N-ethyl itaconimide, N-butyl itaconimide, N-octhyl itaconimide, N-2-ethylhexyl itaconimide, N-cyclohexyl itaconimide, N-lauryl itaconimide,

succinimide-based monomers such as N-(meth)acryloyl oxymethylene succinimide, N-(meth)acryloyl-6-oxyhexamethylene, succinimide, N-(meth)acryloyl-8-oxyoctamethylene succinimide,

vinyl monomers such as vinyl acetate, vinyl propionate, N-vinylpyrrolidone, methyl vinylpyrrolidone, vinyl pyridine, vinyl piperidone, vinyl pyrimidine, vinyl piperazine, vinyl pyrazine, vinyl pyrrole, vinyl imidazole, vinyl oxazole, vinyl morpholine, N-vinyl carboxylic acid amides, styrene, $\alpha$-methyl styrene, N-vinyl caprolactam;

cyanoacrylate-based monomers such as acrylonitrile, metacryloni tril;

epoxy group-containing acrylic monomers such as glycidyl (meth)acrylate;

glycol-based acrylate monomers such as polypropylene glycol (meta)acrylate, methoxyethyl glycol (meta)acrylate, methoxypolypropylene glycol (meta)acrylate;

heterocycles such as tetrahydrofurfuryl, fluorine (meta) acrylate, silicone (meta) acrylate;

acrylate monomers which contains a halogen atom, a silicon atom or the like;

multifunctional monomers such as hexanediol di(meta) acrylate, (poly)ethylene glycol di(meta) acrylate, polypropylene glycol di(meta) acrylate, neopentyl glycol di(meta) acrylate, pentaerythritol di(meta) acrylate, trimethylol propane tri(meta) acrylate, pentaerythritol tri(meta) acrylate, dipentaerythritol hexa(meta) acrylate, epoxy acrylate, polyester acrylate, urethane acrylate, divinylbenzene, butyl di(meta) acrylate, hexyl di(meta) acrylate;

olefine monomers such as isoprene, dibutadiene, isobtylene;

vinyl ether-based monomers such as vinyl ether, or the like. These monomer components may be used singly or in a combination of two or more.

The acrylic copolymer can be produced by polymerizing the above the alkyl (meth)acrylate and the other monomer if desired according to the appropriate known method.

There are no particular restrictions on the molecular weight or the like of the acrylic copolymer, for example, that having the weight average molecular weight of 100,000 to 2,000,000can be used, 150,000 to 1,000,000 is preferable, and 300,000 to 1,000,000 is more preferable. The weight average molecular weight can be measured as a corresponding value of polystylene by gel permeation chromatograph (GPC), for example.

The adhesive can be an energy ray curable adhesive by adding an energy ray polymerizable compound, by incorporating an energy ray polymerizable double bond into the base polymer, or the like. The adhesive layer using the energy curable adhesive exhibits sufficient adhesive forth before energy ray-irradiation and markedly decreases adhesive forth after energy ray-irradiation, therefore, it is possible to easily peel without providing stress to adherend.

Examples of the energy ray include ultraviolet ray, electron ray,or the like.

A compound having 2 or more of energy ray polymerizable carbon-carbon double bond in its molecule can be used as the energy ray polymerizable compound. Examples of such compound include multifunctional acrylic compound, for example.

Examples of the multifunctional acrylic compound include, for example,

(meth) acrylates of a liner aliphatic polyol such as 1,4-butylene di(meth)acrylate, 1,5-pentandiol di(meth)acrylate,1,6-hexanediol di(meth)acrylate, 1,9-nonanediol di(meth)acrylate, polyethylene glycol di(meth)acrylate, polypropylene glycol di(meth)acrylate;

(meth) acrylates of an aliphatic polyol having alicyclic group such as cyclohexane dimethanol di(meth)acrylate, tricyclodecane dimethanol di(meth)acrylate;

(meth) acrylates of a branched chain aliphatic polyol such as trimethylolpropane tri(meth)acrylate, pentaerythritol tri (meth)acrylate, pentaerythritol tetra(meth)acrylate;

condensation products such as ditrimethylolpropane tetraacrylate, dipentaerythritol hexaacrylate, or the like.

These may be used singly or in a combination of two or more.

A multifunctional urethane acrylic oligomer such as an urethane acrylic oligomer can be used as the energy polymerizable compound, for example.

The urethane acrylic oligomer can be obtained by reacting an urethane oligomer which is obtained by reacting a diisocyanate compound with an polyol compound, and an alkyl (meth)acrylate having a hydroxy group, for example.

Examples of the diisocyanate compound include, for example, tolylene diisocyanate, diphenyl methandiisosianate, hexamethylene diisocyanate, phenylene diisosianate, dicyclohexyl methandiisosianate, xylene diisosianate, tetramethylxylene diisosianate, naphthalene diisosianate, isophorone diisosianate, or the like.

Examples of the polyol compound include

polyalcohols such as ethylene glycol, 1,4-buthanediol, 1,6-hexanediol, diethylene glycol, trimethylolpropane, dipropylene glycol, polyethylene glycol, polypropylene glycol, pentaerythritol, dipentaerythritol, glycerin or the like;

polyester-based polyol compounds which is obtained by condensation reacting the polyalcohol and an aliphatic dicarboxylic acid such as adipic acid, sebacic acid, azelaic acid, maleic acid or an aromatic dicarboxylic acid such as terephthalic acid, isophthalic acid;

polyether-based polyol compounds such as polyethylene ether glycol, polypropylene ether glycol, polytetramethylene ether glycol, polyhexamethylene ether glycol;

lactone-based polyol compounds such as polycaprolactone glycol, polypropiolactone glycol, polyvalerolactone glycol;

polycarbonate-based polyol compounds which is obtained by the de-alcoholizing reaction of polyalcohol such as ethylene glycol, propylene glycol, butanediol, pentanediol, octanediol, nonanediol or the like and diethylene carbonate, dipropylene carbonate or the like.

Examples of the hydroxyl group-containing alkyl (meth)acrylate compound include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydodecyl (meth)acrylate, 12-hydroxyrauryl (meth)acrylate, (4-hydroxymethyl cyclohexyl) methyl(meth) acrylate, or the like.

The energy ray polymerizable compound is used in a ratio of 5 to 200 parts by weight to 100 parts by weight of the base polymer, is preferably used in 10 to 100 parts by weight, and is more preferably used in 10 to 45 parts by weight.

A method of incorporating the energy ray polymerizable double bond into the base polymer is a method in which copolymerizable monomers having a reactive functional group such as carboxyl group, hydroxyl group, amino group and the like are copolymerized when an acrylic polymer which is the base polymer, is prepared, for example. This leads the base polymer to incorporate the functional groups which are basic points of the reaction, and allows to bond the multifunctional monomer or oligomer having the energy ray polymerizable double bond to the base polymer via the functional groups which are basic points of the reaction, thereby obtaining a base polymer having the energy ray polymerizable carbon-carbon double bond in the side chain.

The energy ray curable adhesive may include a photopolymerization initiator as required. The photopolymerization initiator causes radicals through excitation and activation by irradiation of the energy ray, and promotes an efficient polymerizing and curing reaction of the adhesive layer.

Examples of the photopolymerization initiator include, for example,

benzoine alkyl ether-based initiators such as benzoine methyl ether, benzoine ethyl ether, benzoine isopropyl ether, benzoine isobutyl ether;

benzophenone-based initiators such as benzophenone, benzoylbenzoate, 3,3'-dimethyl-4-methoxybenzophenone, polyvinyl benzophenone;

aromatic ketone-based initiators such as $\alpha$-hydroxy cyclohexyl phenyl ketone, 4-(2-hydroxy ethoxy) phenyl (2-hydroxy-2-propyl) ketone, $\alpha$-hydroxy-$\alpha,\alpha$'-dimethyl acetophenone, methoxyacetophenone, 2,2-dimethoxy-2-phenyl acetophenone, 2,2-diethoxyacetophenone;

aromatic ketal-based initiators such as the benzyl dimethyl ketal;

thioxanthone-based initiators such as thioxanthone, 2-chlorothioxanthone, 2-methylthioxanthone, 2-ethylthioxanthone, 2-isopropylthioxanthone, 2-dodecylthioxanthone, 2,4-dichlorothioxanthone, 2,4-dimethylthioxanthone, 2,4-diethylthioxanthone, 2,4-diisopropylthioxanthone;

benzyl-based initiators such as benzyl;

benzoin-based initiators such as benzoin;

$\alpha$-ketol-based compounds such as 2-methyl-2-hydroxypropylphenon;

aromatic sulfonyl chloride-based compounds such as 2-naphthalene sulfonyl chloride;

light-active oxime compounds such as 1-phenon-1,1-propanedione-2-(o-ethoxycarbonyl) oxime;

camphor chinone; ketone halide; acyl phosphinoxide; acyl phosphonate and the like. These may be used singly or in a combination of two or more.

The adhesive may be a hydrophilic adhesive which is provided a hydrophilic properties by neutralizing part or all of acidic group contained in the base polymer, which is used a polymer having an acidic group such as carboxy group as the base polymer and is added a neutralizer thereto. The hydrophilic adhesive generally causes the adherend few adhesive residues, and it is possible to remove easily with washing with pure water, even though the adhesive causes adhesive residues.

The polymer having an acidic group can be obtained by copolymerizing the monomers having the acidic group such as carboxyl-containing monomer described above when the base polymer is prepared.

Examples of the neutralizer include, for example, primary amines such as monoethylamine, monoethanolamine; secondary amines such as diethylamine, diethanolamine; tertiary amines such as triethylamine, triethanolamine, N,N,N'-trimethyl ethylenediamine, N-methyl diethanolamine, N,N-diethyl hydroxylamine; organic amino compounds indicating the alkalinity.

The adhesive may include an cross-linker as required.

As the cross-linker, epoxy-based cross-linker, isocyanate-based cross-linker, melamine-based system cross-linker, peroxide-based cross-linker, metal alkoxide-based cross-linker, metal chelate-based cross-linker, metal salt-based cross-linker, carbodiimide-based cross-linker, oxazoline-based cross-linker, aziridine-based cross-linker, amine-based cross-linker can be used. The epoxy based cross-linker and isocyanate-based cross-linker can be preferably used. These may be used singly or in a combination of two or more.

Examples of the epoxy-based cross-linker include, for example, N, N, N',N'-tetraglycidyl-m-xylene diamine, diglycidyl aniline, 1,3-bis(N,N-glycidyl amino methyl) cyclohexane, 1,6-hexanediol diglycidyl ether, neopentylglycol diglycidyl ether, ethylene glycol diglycidyl ether, propylene glycol diglycidyl ether, polyethylene glycol diglycidyl ether, polypropylene glycol diglycidyl ether, sorbitol polyglycidyl ether, glycerol polyglycidyl ether, pentaerythritol polyglycidyl ether, polyglycerol polyglycidyl ether, sorbitan polyglycidyl ether, trimethylolpropane polyglycidyl ether, diglycidyl adipate, diglycidyl o-phthalate, triglycidyl-tris(2-hydroxyethyl) isocyanurate, resorcin diglycidyl ether, bisphenol-S-diglycidyl ether, an epoxy resin having 2 or more of epoxy gorup in its molecule or the like.

Examples of the isocyanate-based cross-linker include, for example, lower aliphatic polyisocyanates such as 1,2-ethylene diisocyanate, 1,4-butylene diisocyanate, 1,6-hexamethylene diisocyanate; aliphatic polyisocyanates such as cyclopentylene diisocyanate, cyclohexylene diisocyanate, isophorone diisocyanate, hydrogenation tolylene diisocyanate, hydrogenation xylene diisocyanate; aromatic polyisocyanates such as 2,4-tolylene diisocyanate, 2,6-tolylene diisocyanate, 4,4'-diphenyl methane diisocyanate, xylylene diisocyanate, or the like.

The adhesive layer may be formed by applying the adhesive onto the base substrate with an appropriate method using a knife coater, roll coater, gravure coater, die coater, reverse coater, or the like. Furthermore a method can be used in which the adhesive layer formed on an appropriate casting-step sheet such as a film exfoliate-processed on its surface, and then transfered to the base substrate.

There is no particular limitation on the thickness of the adhesive layer, it is preferably 10 $\mu$m or more (for example, 10 to 200$\mu$m), more preferably 15 $\mu$m or more (for example, 15 to 100$\mu$pm), and still more preferably 18 $\mu$m or more (for example, 18 to 50$\mu$m). When the thickness of the adhesive layer is in the above range, stress of the base substrate is reduced, and it is possible to improve the percentage of stress relaxation.

The modulus of elasticity of the adhesive layer is preferably in the range of substantially $1.0 \times 10^4$ to $1.0 \times 10^7$. When the modulus of elasticity is in the above range, adhesive characteristics can be expressed that are adapted for use as an adhesive sheet for back grinding processing of a semiconductor wafer.

When the energy ray curable adhesive is used as the adhesive, the modulus of elasticity is the modulus of elasticity of the adhesive layer before curing (before irradiation with the energy beam).

(Base substrate)

The base substrate used in the present invention is not particularly limited, for example, a resin (plastic) film can be used.

The resin configuring the resin film is not particular limited, and may be any of the curable resin (thermo-setting resin, light curable resin, or the like) and the thermoplastic resin.

Examples thereof include, for example,

polyolefins such as liner chain polyethylene, medium-density polyethylene, high-density polyethylene, very low-density polyethylene, random copolypropylene, block copolypropylene, homopolypropylene, polybutene, polymethylpentene; polyolefin-based resins ethylene-vinyl acetate copolymer, ionomer resin, ethylene-(meth)acrylic acid copolymer, ethylene-(meth)acrylic ester (random, alternating) copolymer, ethylene-butene copolymer, ethylene-hexene copolymer;

polyester-based resins such as polyurethane, polyethylene terephthalate, polyethylene naphthalate; (meta)acrylic polymers, polystyrene, polycarbonate, polyimide, polyamide, polyamide-imide, polyetherimide, polysulfone, polyether sulfone, polyvinyl chloride, polyvinylidene chloride, fluoric resin, cellulose resin and cross-linked thereof. These materials which blended several kinds as needed may be used.

Addtives which are an inorganic filler such as calcium carbonate, silica, mica or the like; a metallic filler such as iron, lead or the like; a colorant such as pigment, die or the like can be contained in the resin as described above.

Use of a resin exhibiting high stress relaxation characteristics such as a thermoplastic elastomer or the like as the material forming the base substrate is preferred in light of improving the percentage of stress relaxation of the adhesive sheet. The base substrate may be a single-layer film, or may be a laminate (multilayer film) adapted to utilize the advantages of the respective resins.

The laminate may be exemplified by a laminated film formed from a middle layer and a surface layer provided on at least one surface of the middle layer. The surface layer is preferably provided on both surfaces of the middle layer to thereby provide three layers of surface layer/middle layer/surface layer. The material used to configure the middle layer and the surface layer for example is preferably a polyolefin resin as described above or a polyolefin resin irradiated using an electron beam of 1 to 80 Mrad or a γ beam.

The material used to configure the respective middle layers and surface layers is preferably selected from polyolefin resins having different heat shrinkage ratios so that the heat shrinkage ratio of the overall base substrate is suppressed by the mutual buffering of each layer. The type of combination for example includes a combination of polyethylene and polypropylene, and in particular, a combination of crystalline polyethylene and non-crystalline polypropylene is preferred. When a laminate of polyethylene and polypropylene is used as the base substrate, provision of a layer configured with polyethylene on the side making contact with the adhesive layer of the base substrate is preferred in view of superior anchoring performance. In a configuration in which the laminate has a surface layer on both sides of the middle layer, it is preferred that the two surface layers are configured from the same type of material.

There is no particular limitation on the ratio of the thickness of each layer configuring the laminate, and it is preferred that the thickness of the middle layer is greater than the thickness of the surface layer. The ratio of thicknesses for example may be one surface layer: middle layer = 1:12 to 3:5, and preferably 1:10 to 3:10. The thickness of one surface layer to the other surface layer when a surface layer is provided on both surfaces of the middle layer may be the same or different. Although the thickness of one surface layer to the thickness of the other surface layer may be selected from a range of 1:1 to 1:5, the thickness of the two surface layers is preferably the same. Of such ranges, a multilayer film having a thickness ratio substantially of surface layer: middle layer : surface layer = about 2:9:2 is in particular capable of suitable use.

A suitable middle layer may be provided as required between the middle layer and the surface layer. The middle layer includes an adhesive layer for improving the tight adhesion between the layers, or an undercoated layer, or the like.

There is no particular limitation on the method of preparing the base substrate and examples of the method include a method of dissolving pellet-configured resin to form a film by use of an extrusion film-forming apparatus, or a method of manufacture using an extrusion molding with a T die or an inflation method, or by a calendaring method.

The heat shrinkage ratio of the adhesive sheet, and in particular, the base substrate is preferably less than or equal to 2%. The heat shrinkage ratio of the base substrate depends substantially on the temperature conditions in the film forming step, and therefore it is desirable to select a base substrate that does not include an extension step in the film forming step.

Tight adhesion with the adhesive of the upper surface of the base substrate, that is to say, the surface on the side provided with the adhesive sheet layer may be improved by application of typical surface processing, for example, an oxidizing process using a chemical or physical process such as corona treatment, chromic acid treatment, ozone exposure, exposure to a flame, high-voltage electrical shock exposure, ionizing radiation treatment, or the like.

The thickness of the base substrate may be adjusted in response to the characteristics of the adhesive sheet to be produced, or the like, and for example, is 30 to 1000 μm, preferably 40 to 800 μm, more preferably 50 to 500 μm, and still more preferably 100 to 200 μm.

The adhesive sheet for processing of the semiconductor wafer according to the present invention may form an adhesive layer on the base substrate as described above to thereby protect the adhesive layer by a suitable separator as required.

The adhesive sheet for processing of the semiconductor wafer may have a configuration of winding into a roll shape, or may have a configuration such as a sheet shape, tape shape, or the like.

The adhesive sheet for processing of the semiconductor wafer according to the present invention for example, may be used as a surface protecting sheet for various types of adherends such as electronic components, and in particular may be used as a protective adhesive sheet for protecting the circuit surface of a semiconductor wafer when grinding the semiconductor wafer (back grind sheet), a sheet for protecting and/or processing during dicing, and a processing adhesive sheet in respective steps of semiconductor wafer processing.

For example, during the back grinding step of the semiconductor wafer, firstly the adhesive layer of the adhesive sheet for processing of the semiconductor wafer according to the present invention is attached to the wafer surface (pattern circuit forming surface). The attachment step is performed by use of an apparatus termed a laminator.

Next, the wafer back surface is ground to a predetermined thickness (for example, 50 to 200 μm) using a grinder or the like, and then chemical polishing by etching or the like is performed as required. The adhesive sheet for processing of the semiconductor wafer has the role of fixing the semiconductor wafer, protecting the semiconductor wafer surface (pattern circuit forming surface) and preventing contamination or breakage of the wafer surface.

After completion of back grinding processing of the wafer, the adhesive sheet for processing of the semiconductor wafer is peeled from the adherend.

For example, when the adhesive sheet for processing of the semiconductor wafer according to the present invention is adhered to the circuit pattern forming surface of the semiconductor wafer, superior conforming performance to the steps forming the circuit pattern is enabled, and stabilization of a lifting amount over time is enabled. As a result, advantages during use are also improved.

That is to say, as illustrated in FIG. 1A and 1B, in the adhesive sheet according to the present invention, if the film thickness of the adhesive layer in the adhesive sheet 12 is taken to be A $\mu$m, and the step 11 on the surface of the wafer 10 is taken to be B $\mu$m, when the film thickness A and the step B satisfies the relation $0.2 \leq B/A \leq 5.7$, it can be confirmed that the initial lift amount d1 of the adhesive sheet 12 from the step 11 (FIG. 1A) and the lift amount d2 of the adhesive sheet after 24 hours (FIG. 1B) satisfy the relation in Formula (5).

$$(d2/d1) \times 100 \leq 110 \ (\%) \qquad (5)$$

Furthermore, it is preferred that (d2/d1) x 100 is less than or equal to 109%.

Conventionally, although the surfactant is contained in the adhesive layer as an adhesive force adjustment component when peeling the adhesive sheet for processing of the semiconductor wafer from the adherend, the pattern surface of the semiconductor wafer has been contaminated by deposition of this component onto the adhesive layer surface. In the dicing step of the semiconductor wafer, although individual IC units are formed while applying a large amount of water onto the semiconductor wafer, there is also a similar risk of contamination originating from a stain at this time.

However, in the adhesive sheet according to the present invention, the selection of a specific combination of plasticizer and surfactant enables effective prevention of deposition of a stain originating in the adhesive component even when used or stored under a variety of environments. Consequently, after processing of the semiconductor wafer such as back grinding, when peeling the adhesive sheet attached to the semiconductor wafer surface, contamination of the wafer surface by a stain can be prevented, and suitable use is enabled as a surface protecting sheet during storage, transportation or processing of an adherend, such as a semiconductor wafer, that requires a level of cleanliness. Furthermore, productivity can be effectively improved by omission, simplification or the like of the washing step or the like.

In addition, since the adhesive sheet according to the present invention does not use a phthalate ester, the adhesive sheet can comply with environmental concerns.

Examples

The present invention will now be described in detail through reference to Examples. The present invention is not, however, limited to or by these examples.

Example 1

An acrylic polymer having a weight average molecular weight of 550,000 was obtained by a solution polymerization method by use of toluene to copolymerize 97 parts by weight of butyl acrylate, 2 parts by weight of methyl methacrylate, and 3 parts by weight of acrylic acid. An adhesive composition A was obtained by mixing 10 parts by weight of an adipic-based polyester (trade name: "W-230H" manufactured by Dainippon Ink) as a plasticizer, 1 part by weight of a non-ionic surfactant (trade name: "Noigen EP-120A" manufactured by Dai-Ichi Kogyo Seiyaku) as an adhesive strength adjusting component, 0.5 parts by weight of an epoxy cross-linker (trade name: "TETRAD C" manufactured by Mitsubishi Gas Chemical Company), and 3 parts by weight of a polyisocyanate-based cross-linker (trade name: "Coronate L" manufactured by Nippon Polyurethane Industry).

An adhesive layer was formed by coating the resulting adhesive composition A using a fountain die method onto a casting-step sheet (PET film of 50 $\mu$m thickness manufactured by Toray) to achieve a thickness of 45 $\mu$m after drying. A 135 $\mu$m laminated film A formed from three layers of polyethylene/non-crystalline polypropylene/polyethylene was manufactured as the base substrate by co-extrusion using an extrusion apparatus. The ratio of the thickness of each layer of the laminated film A is polyethylene:non-crystalline polypropylene:polyethylene = 2:9:2.

The adhesive layer A was laminated by transferring onto the laminate film A and aged for 48 hours at 50°C to thereby obtain an adhesive sheet A.

Example 2

An adhesive composition B was obtained by mixing 30 parts by weight of a trimellitic acid-based polyester (trade name: "W-705" manufactured by Dainippon Ink) as a plasticizer, 1 part by weight of a non-ionic surfactant (trade name: "Noigen EP-120A" manufactured by Dai-Ichi Kogyo Seiyaku) as an adhesive strength adjusting component, 0.5 parts by weight of an epoxy cross-linker (trade name: "TETRAD C" manufactured by Mitsubishi Gas Chemical Company), and 3 parts by weight of a polyisocyanate-based cross-linker (trade name: "Coronate L" manufactured by Nippon Polyurethane Industry).
A adhesive sheet B was obtained in the same manner as the Example 1 with the exception that the adhesive composition B was used in stead of the adhesive composition A.

Example 3

An adhesive composition C was obtained by mixing 50 parts by weight of a benzoic acid-based polyester (trade name: "W-83" manufactured by Dainippon Ink) as a plasticizer, 1 part by weight of a non-ionic surfactant (trade name: "Noigen EP-120A" manufactured by Dai-Ichi Kogyo Seiyaku) as an adhesive strength adjusting component, 0.5 parts by weight of an epoxy cross-linker (trade name: "TETRAD C" manufactured by Mitsubishi Gas Chemical Company), and 3 parts by weight of a polyisocyanate-based cross-linker (trade name: "Coronate L" manufactured by Nippon Polyurethane Industry).
A adhesive sheet C was obtained in the same manner as the Example 1 with the exception that the adhesive composition B was used in stead of the adhesive composition A.

Example 4

An adhesive composition D was obtained by mixing 10 parts by weight of an adipic acid-based polyester (trade name: "W-230H" manufactured by Dainippon Ink) as a plasticizer, 5 part by weight of a non-ionic surfactant (trade name: "Noigen EP-120A" manufactured by Dai-Ichi Kogyo Seiyaku) as an adhesive strength adjusting component, 0.5 parts by weight of an epoxy cross-linker (trade name: "TETRAD C" manufactured by Mitsubishi Gas Chemical Company), and 3 parts by weight of a polyisocyanate-based cross-linker (trade name: "Coronate L" manufactured by Nippon Polyurethane Industry).
A adhesive sheet D was obtained in the same manner as the Example 1 with the exception that the adhesive composition D was used in stead of the adhesive composition A.

Example 5

An adhesive composition E was obtained by mixing 30 parts by weight of an adipic acid-based polyester (trade name: "W-230H" manufactured by Dainippon Ink) as a plasticizer, 10 part by weight of a non-ionic surfactant (trade name: "Noigen EP-120A" manufactured by Dai-Ichi Kogyo Seiyaku) as an adhesive strength adjusting component, 0.5 parts by weight of an epoxy cross-linker (trade name: "TETRAD C" manufactured by Mitsubishi Gas Chemical Company), and 3 parts by weight of a polyisocyanate-based cross-linker (trade name: "Coronate L" manufactured by Nippon Polyurethane Industry).
A adhesive sheet E was obtained in the same manner as the Example 1 with the exception that the adhesive composition E was used in stead of the adhesive composition A.

Comparative Example 1

A adhesive sheet F was obtained in the same manner as the Example 1 with the exception that 30 parts by weight of a phthalate (trade name: "DOP" manufactured by Dainippon Ink) as a plasticizer.

Comparative Example 2

A adhesive sheet G was obtained in the same manner as the Example 1 with the exception that 10 parts by weight of a polyether-based polyester (trade name: "AS-200" manufactured by Dainippon Ink) as a plasticizer.

Comparative Example 3

A adhesive sheet H was obtained in the same manner as the Example 1 with the exception that 50 parts by weight of a polyether-based polyester (trade name: "AS-200" manufactured by Dainippon Ink) as a plasticizer.

(test evaluation).

The evaluation test below was performed in relation to the adhesive sheets obtained from the example and a comparative example. The results are shown in Table 2.

[Storage Stability Test]

The adhesive sheets obtained from the example and the comparative example were left for 30 days in an environment of 0°C and 40°C x 92% RH. Then the adhesive sheets were cut into 50 x 50 mm pieces to obtain a test piece. The test pieces were attached without application of tension at a rate of 10 cm/sec to a 4-inch mirror wafer surface using a 2 kg rubber roller. After attachment, the test pieces were peeled at a rate of 300 mm/min and visual observation of the mirror wafer surface state was performed. In the observation method, the attachment surface of the test piece is divided into sizes or 5 x 5 mm to thereby prepare 100 cells and execute visual observation of the number of cells having a stain attached thereto.

○: no stain observed in any of 100 cells
Δ: stain observed in less than 50 cells
X: stain observed in 50 cells or more.

[Adhesive Force on Mirror Wafer]

Measurement was performed using mirror wafer as adherend based on JIS Z-0237.

[Gel Fraction of Adhesive]

An adhesive is extracted from the adhesive sheet, the weight ($W_1$) of the extracted adhesive is measured , and after one week immersion of the adhesive in ethyl acetate, the solvent portion is dried, and the weight of the residual gel ($W_2$) is measured to thereby obtain a value calculated by the following formula.

$$\text{Gel fraction (\%)} = W_2 \times 100 / W_1$$

[Step Conformability Test]

The adhesive sheets obtained from the example and the comparative example are adhered to a mirror wafer at an adhesion rate of 10mm/second at an adhesion pressure of 0.4 MPa and using a DR3000II manufactured by Nitto Seiki. At that time, a dummy step was formed by adhering of a 53 $\mu$m thickness tape onto the mirror wafer in an orientation perpendicular to the direction of adhering of the adhesive sheet.
After adhesion of the adhesive sheet, the distance of lifting of the tape from the dummy step was evaluated using an optical microscope to thereby obtain an initial step lift amount (refer to d1 in FIG. 1A). Then after 24 hours in an adhered configuration, the same evaluation was performed to thereby measure the lift amount over time (refer to d2 in FIG. 1B), and a lifting ratio is calculated from the initial lift amount using the following formula.

$$\text{Temporal stability (\%)} = (d2 / d1) \times 100$$

[Table 2]

| | | Plasticizer | | Surfactant parts by wt. | Plasticizer SP value $\delta p$ | Surfactant SP value $\delta s$ | $\delta p/\delta s$ |
|---|---|---|---|---|---|---|---|
| | | Kinds | Parts by wt. | | | | |
| Ex. | 1 | adipic acid -based polyester | 10 | 1 | 9.2 | 9.91 | 0.93 |
| | 2 | trimellitic acid -based polyester | 30 | 1 | 9.0 | 9.91 | 0.91 |
| | 3 | benzoic acid -based ester | 50 | 1 | 9.8 | 9.91 | 0.99 |
| | 4 | adipic acid -based polyester | 10 | 5 | 9.2 | 9.91 | 0.93 |
| | 5 | adipic acid -based polyester | 10 | 10 | 9.2 | 9.91 | 0.93 |
| Comp. Ex. | 1 | phthalic acid ester | 30 | 1 | 8.9 | 9.91 | 0.89 |
| | 2 | polyether-based polyester | 10 | 1 | 8.4 | 9.91 | 0.85 |
| | 3 | polyether-based polyester | 50 | 1 | 8.4 | 9.91 | 0.85 |

| | | Adhesive Force (N/20mm) | Gel Fraction (%) | 0℃ | | 40℃ 92%RH | | initial lift amount (μm) | Stability over time (%) |
|---|---|---|---|---|---|---|---|---|---|
| | | | | Number of contamination observed | Storage Stability | Number of contamination observed | Storage Stability | | |
| Ex. | 1 | 0.51 | 38 | 0/100 | ○ | 0/100 | ○ | 280 | 100.4 |
| | 2 | 0.43 | 44 | 0/100 | ○ | 0/100 | ○ | 311 | 103.5 |
| | 3 | 0.36 | 58 | 0/100 | ○ | 0/100 | ○ | 425 | 101.1 |
| | 4 | 0.20 | 36 | 0/100 | ○ | 0/100 | ○ | 368 | 101.8 |
| | 5 | 0.15 | 32 | 0/100 | ○ | 0/100 | ○ | 316 | 105.8 |
| Comp. Ex. | 1 | 0.41 | 35 | 0/100 | ○ | 31/100 | △ | 555 | 110.2 |
| | 2 | 0.68 | 31 | 56/100 | × | 91/100 | × | 648 | 121.7 |
| | 3 | 0.27 | 69 | 51/100 | × | 69/100 | × | 581 | 117.0 |

(Experimental Example)

An adhesive sheet is manufactured in the same manner as Example 1 with the exception of varying the thickness of the adhesive layer to 15 to 65 μm. The resulting adhesive sheet is tested by varying the step between 18 to 85 μm according to the above step conformability test. The results are shown in the table below.

[Table 3]

| Step Thickness of adhesive layer | 18μm | 30μm | 53μm | 85μm |
|---|---|---|---|---|
| 15μm | 102.4% | 105.8% | 108.3% | 106.5% |
| 45μm | 100.3% | 104.6% | 102.9% | 107.0% |
| 65μm | 101.2% | 100.4% | 100.9% | 105.1% |

Industrial Applicability

The adhesive sheet for processing of a semiconductor wafer according to the present invention enables various applications including a processing sheet during dicing, a surface protecting sheet for various adherends such as electronic components, or the like.

**Claims**

1.  An adhesive sheet for processing of a semiconductor wafer comprising an adhesive layer disposed on at least one surface of a base substrate,
    the adhesive layer includes a base polymer, a polyester-based plasticizer and a surfactant,
    SP values of the plasticizer and the surfactant satisfy the relationship:

$$0.9 \leq (SP\ value\ of\ the\ plasticizer)/(SP\ value\ of\ the\ surfactant) \leq 1.0.$$

2.  The adhesive sheet for processing of a semiconductor wafer of claim 1, wherein the plasticizer is contained in a ratio of 10 to 50 parts by weight to 100 parts by weight of the base polymer.

3.  The adhesive sheet for processing of a semiconductor wafer of claim 1 or 2, wherein the surfactant is contained in a ratio of 1 to 10 parts by weight to 100 parts by weight of the base polymer.

4.  The adhesive sheet for processing of a semiconductor wafer any one of claims 1 to 3, wherein the base polymer includes an acrylic polymer.

5.  The adhesive sheet for processing of a semiconductor wafer any one of claims 1 to 4, wherein
    when the film thickness of the adhesive layer in the adhesive sheet is taken to be A μm, and a step on the surface of the wafer is taken to be B μm, and the film thickness A and the step B satisfies the relation $0.2 \leq B/A \leq 5.7$,
    the initial lift amount d1 of the adhesive sheet from the step and the lift amount d2 of the adhesive sheet after 24 hours satisfy

$$(d2/d1) \times 100 \leq 110\ (\%).$$

[Fig. 1A]

[Fig. 1B]

## INTERNATIONAL SEARCH REPORT

| | International application No. |
|---|---|
| | PCT/JP2011/059247 |

**A. CLASSIFICATION OF SUBJECT MATTER**
*H01L21/301*(2006.01)i, *C09J7/02*(2006.01)i, *C09J11/06*(2006.01)i, *C09J133/04* (2006.01)i, *C09J167/00*(2006.01)i, *H01L21/304*(2006.01)i

According to International Patent Classification (IPC) or to both national classification and IPC

**B. FIELDS SEARCHED**

Minimum documentation searched (classification system followed by classification symbols)
H01L21/301, C09J7/02, C09J11/06, C09J133/04, C09J167/00, H01L21/304

Documentation searched other than minimum documentation to the extent that such documents are included in the fields searched
Jitsuyo Shinan Koho        1922-1996    Jitsuyo Shinan Toroku Koho   1996-2011
Kokai Jitsuyo Shinan Koho   1971-2011    Toroku Jitsuyo Shinan Koho   1994-2011

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2004/111148 A1 (Hitachi Chemical Co., Ltd.), 23 December 2004 (23.12.2004), & JP 2004-211053 A        & JP 2010-18814 A & JP 2004-83836 A        & JP 2004-292821 A & JP 2006-144022 A        & US 2007/0098995 A1 & KR 10-2006-0018876 A   & CN 1802421 A & CN 101266925 A | 1-5 |
| A | JP 2005-322790 A (Toyo Tire and Rubber Co., Ltd.), 17 November 2005 (17.11.2005), (Family: none) | 1-5 |

☐ Further documents are listed in the continuation of Box C.          ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 18 May, 2011 (18.05.11) | 31 May, 2011 (31.05.11) |

| Name and mailing address of the ISA/ | Authorized officer |
|---|---|
| Japanese Patent Office | |
| Facsimile No. | Telephone No. |

**EP 2 562 795 A1**

## REFERENCES CITED IN THE DESCRIPTION

**Patent documents cited in the description**

- JP 5335288 A

**Non-patent literature cited in the description**

- SP Chi no K. Oyo to Keisanhoho. 54-56